# EUROPÄISCHE PATENTSCHRIFT

(11) **EP 1 314 344 B1**
(45) Veröffentlichungstag und Bekanntmachung des Hinweises auf die Patenterteilung: **06.08.2008**
(21) Anmeldenummer: 01969607.9
(22) Anmeldetag: 17.08.2001
(51) Int. Cl.: H05K 7/14

(54) **BETÄTIGUNGSELEMENT ZUM EIN- UND AUSHEBELN VON FLACHBAUGRUPPEN MIT VERRIEGELUNGSELEMENT IN MINDESTENS DREI SCHALTSTELLUNGEN, FRONTELEMENT FÜR EINE FLACHBAUGRUPPE MIT BETÄTIGUNGSELEMENT UND BAUGRUPPENTRÄGER ZUR AUFNAHME VON FLACHBAUGRUPPEN**
ACTUATING ELEMENT COMPRISING A LOCKING ELEMENT FOR INSERTING AND REMOVING FLAT MODULES BY LEVERAGE IN AT LEAST THREE CONNECTION POSITIONS, FRONT ELEMENT FOR A FLAT MODULE, COMPRISING AN ACTUATING ELEMENT AND A SUBASSEMBLY SUPPORT FOR RECEIVING FLAT MODULES
ELEMENT D'ACTIONNEMENT POURVU D'UN ELEMENT DE VERROUILLAGE POUR FAIRE ENTRER ET SORTIR PAR UN MOUVEMENT DE LEVIER DES MODULES PLATS EN AU MOINS TROIS POSITIONS DE CONNEXION, ELEMENT FRONTAL POUR MODULE PLAT AVEC ELEMENT D'ACTIONNEMENT ET SUPPORT DE MODULES DESTINE A RECEVOIR DES MODULES PLATS

(30) Priorität: 17.08.2000 DE 20014195 U
(43) Veröffentlichungstag der Anmeldung: 28.05.2003
(73) Patentinhaber: Rittal Electronic Systems GmbH & Co. KG, 35745 Herborn (DE)
(72) Erfinder: KOERBER, Werner, 91282 Betzenstein (DE); SCHAFFER, Kurt, Michael, 90542 Eckental (DE); BEHRENS, Ralf, 90419 Nürnberg (DE)
(74) Vertreter: Fleck, Hermann-Josef
(86) Internationale Anmeldenummer: PCT/EP2001/009522
(87) Internationale Veröffentlichungsnummer: WO 2002/015656

(56) Entgegenhaltungen:
- EP-A- 0 313 270
- DE-U- 29 922 725
- US-A- 5 959 843

## Beschreibung

Die Erfindung betrifft ein Betätigungselement zum Ein- und Aushebeln einer Flachbaugruppe mit den Merkmalen des Oberbegriffs des Patentanspruchs 1. Ferner betrifft die Erfindung ein Frontsystem für eine Flachbaugruppe mit mindestens einem derartigen Betätigungselement, eine zugehörige Flachbaugruppe sowie einen Baugruppenträger zur ein- und aushebelbaren Aufnahme derartiger Flachbaugruppen mit einem Frontsystem.

Als Stand der Technik ist aus der US-A-5 959 843 (vgl. die nachveröffentlichte Gebrauchsmusteranmeldung 299 22 725.1 (Siemens)) ein Betätigungselement zum Ein- und Aushebeln einer Flachbaugruppe mit einem Endstück bekannt, welches zur Verbindung mit einer Flachbaugruppe vorbereitet ist und einen Betätigungshebel aufweist, der drehbar am Endstück gelagert ist.

Das Betätigungselement besitzt ein Verriegelungselement, welches in einer Schaltstellung ein Aushebeln des Betätigungshebels ermöglicht und in einer anderen Schaltstellung dies unterbindet. Eine definierte Betätigung oder Entlastung eines in einem Endstück eines derartigen Betätigungselements integrierten Schaltelements findet nicht statt.

Der Erfindung liegt die Aufgabe zugrunde, ein Betätigungselement zum Ein- und Aushebeln einer Flachbaugruppe anzubieten, welches ein definiertes Betätigen oder Entlasten eines integrierten Schaltelements ermöglicht. Ferner soll ein zugehöriges Frontsystem für eine derartige Flachbaugruppe, eine Flachbaugruppe mit einem derartigen Frontsystem sowie ein Baugruppenträger zur ein- und aushebelbaren Aufnahme derartiger Flachbaugruppen angeboten werden.

Die Aufgabe wird für das Betätigungselement durch die Merkmale des kennzeichnenden Teils des Patentanspruchs 1 in Verbindung mit den Merkmalen des Oberbegriffs gelöst. Vorteilhafte Ausführungsformen des Betätigungselements sind in den Unteransprüchen 2 - 9 beschrieben. Für das Frontsystem wird die Aufgabe durch die Merkmale des Patentanspruchs 10, für die Flachbaugruppe durch die Merkmale des Patentanspruchs 11 und für den Baugruppenträger durch die Merkmale des Patentanspruchs 12 gelöst.

Beim erfindungsgemäßen Betätigungselement ist eine dritte Schaltstellung des Verriegelungselements vorgesehen, in welcher der Betätigungshebel des Betätigungselements weiterhin in einer ersten Position gehalten wird, welche einem eingehebelten Zustand der Flachbaugruppe entspricht, wobei ferner eine Entlastung eines integrierten Schaltelements erfolgt. Damit sind insgesamt beim erfindungsgemäßen Betätigungselement zumindest drei Schaltstellungen A, B und C vorhanden, wodurch eine Entlastung eines integrierten Schaltelements ohne gleichzeitige Lösung der Arretierung des Betätigungshebels stattfindet. Damit kann durch Verstellen, insbesondere Verschieben des Verriegelungselements in zwei Schaltstellungen A und C eine Betätigung (1. Schaltzustand) und Entlastung (2. Schaltzustand) des integrierten Schaltelements stattfinden, ohne dass eine Lösung der Arretierung des Betätigungshebels wie in Schaltstellung B stattfindet.

Bei einem Aushebeln des Betätigungshebels wird damit beim Verschieben des Verriegelungselements von einer ersten Schaltstellung A (Betätigung des Schaltelements und Arretierung des Betätigungshebels) in einer insbesondere mittleren Schaltstellung C zunächst die Betätigung des Schaltelements aufgehoben, wobei die Arretierung des Betätigungshebels fortbesteht. Erst dann, wenn das Verriegelungselement in eine Schaltstellung B verschoben wird, wird die Arretierung des Betätigungshebels aufgehoben und der freigegebene Betätigungshebel kann zum Aushebeln der Flachbaugruppe abgedreht werden.

Um die beschriebenen getrennten und aufeinanderfolgenden Vorgänge der Arretierung bzw. Lösung des Betätigungshebels und Betätigung bzw. Entlastung des Schaltelements konstruktiv zu realisieren, besitzt das Verriegelungselement insbesondere einen Schaltschieber zur Betätigung eines Schalthebels des Schaltelements sowie Verriegelungsmittel, insbesondere eine Gleitkante, welche auf einem korrespondierenden Gleitanschlag des Betätigungselements abgleitet und letzteren entweder kontaktiert, wobei der Betätigungshebel arretiert bleibt, oder freigibt, wobei der Betätigungshebel ebenfalls freigegeben wird und zur Vorbereitung eines Aushebelns der Flachbaugruppe abgedreht werden kann.

Beim erfindungsgemäßen Frontsystem für eine Flachbaugruppe ist eine Frontplatte mit mindestens einem erfindungsgemäßen Betätigungselements vorgesehen. Ferner ist eine Flachbaugruppe vorgesehen, welche ein Frontsystem mit einem erfindungsgemäßen Betätigungselements aufweist. Schließlich umfasst die Erfindung einen Baugruppenträger mit mindestens einer Flachbaugruppe mit einem Frontsystem mit einem erfindungsgemäßen Betätigungselement.

Die Erfindung ist anhand von Ausführungsbeispielen in den Zeichnungsfiguren näher erläutert. Es zeigen:
- FIG 1: eine perspektivische Seitenansicht einer prinzipiellen Ausführung eines Betätigungselements nach dem Stand der Technik,
- FIG 2: eine seitliche Draufsicht auf ein Frontsystem für eine Flachbaugruppe mit einem Betätigungselement gemäß dem Stand der Technik nach FIG 1,
- FIG 3: eine seitliche Teilschnittdarstellung eines erfindungsgemäßen Betätigungselements mit Verriegelungselement in Schaltstellung A,
- FIG 4: eine seitliche Teilschnittdarstellung eines erfindungsgemäßen Betätigungselements gemäß FIG 3 mit Verriegelungselement in Schaltstellung C sowie
- FIG 5: eine seitliche Teilschnittdarstellung eines erfindungsgemäßen Betätigungselements gemäß FIG 3 mit Verriegelungselement in Schaltstellung B.

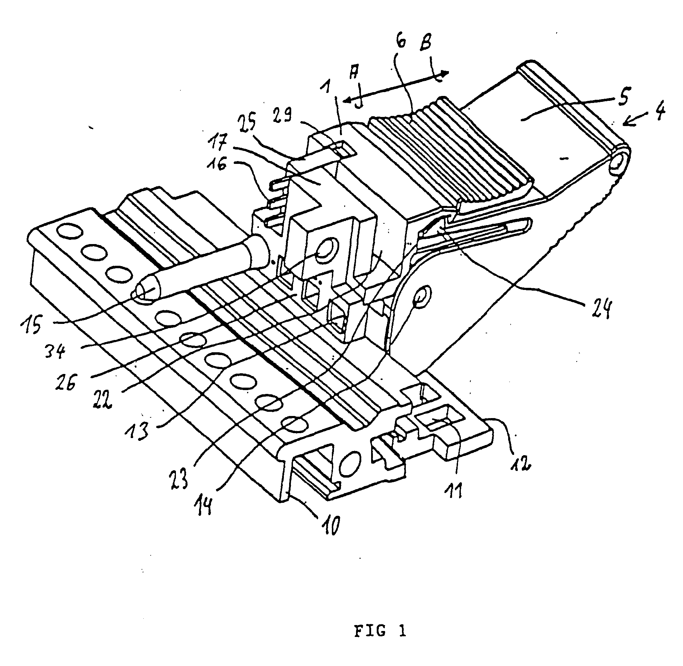

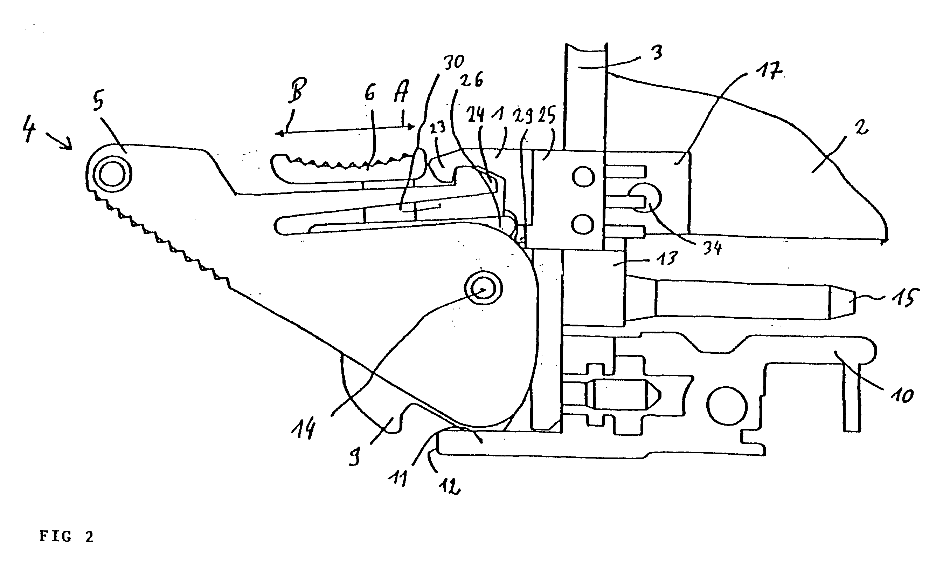

FIG 1 zeigt ein Betätigungselement nach dem Stand der Technik zum Ein- und Aushebeln einer Flachbaugruppe 2 mit einem Endstück 1 zur Verbindung mit einer Flachbaugruppe 2 und einer Frontplatte 3 (vgl. auch FIG 2).

Das Betätigungselement ruht dabei auf einer unteren Querschiene 10 eines Baugruppenträgers und weist dabei als Hauptkomponenten einen Betätigungshebel 4, ein Endstück 1 und eine aus Gründen der Übersichtlichkeit in FIG 1 nicht dargestellte Frontplatte 3 auf. Dem Endstück 1 kommt dabei eine zentrale Haltefunktion zu, da es zum einen als Träger für den insbesondere über eine Bohrung 14 drehbar gelagerten Betätigungshebel 4 dient. Andererseits kann es auch zur Halterung des unteren Endes der Frontplatte 3 dienen, welche hierzu vorteilhaft in eine Nut 22 eingeschoben wird.

Die Verbindung zwischen dem unteren Endstück 1 und der vorderen, unteren Ecke der Flachbaugruppe 2 (vgl. FIG 2) erfolgt bevorzugt über einen Halteblock 17 mittels einer in eine Bohrung 34 eingreifenden Schraube.

Schließlich können noch weitere Komponenten an einem derartigen Endstück 1 angebracht sein. So enthält das in FIG 1 dargestellte Endstück 1 einen Kodierblock 13, in welchem Kodierkammern 27 zum Einsetzen von nicht abgebildeten Kodierstiften eingebracht sind. Diese können in gegenüberliegend an der unteren Querschiene 10 angebrachten Kodierkammern eingreifen, welche mit komplementär kodierten Kodierstiften bestückt sind. Hiermit kann sichergestellt werden, dass nur eine bestimmte, ausgewählte Flachbaugruppe 2 in einem Steckplatz eines Baugruppenträgers positionierbar ist. Schließlich ist noch ein Führungsstift 15 vorhanden, welcher nach Eingriff in eine gegenüberliegende nicht abgebildete Führungsbohrung ein verkantfreies, ordnungsgemäßes Einschieben der Flachbaugruppe 2 gewährleistet.

Zum Ein- bzw. Aushebeln der Flachbaugruppe in den bzw. aus dem entsprechenden Steckplatz dient der Betätigungshebel 4, welcher durch Betätigung des Griffteils 5 bei Verbringung des Verriegelungselements 6 in Schaltstellung (B) bedient werden kann.

Beim Aushebeln muss der Betätigungshebel 4 nach unten gedrückt werden, so dass sich mindestens eine auf der Unterseite vorspringende Aushebelnase 9 an einer Stirnkante 12 der unteren Querschiene 10 abstützen kann. Umgekehrt muss beim Einhebeln der Betätigungshebel 4 nach oben gedrückt werden, so dass sich mindestens eine ebenfalls auf der Unterseite vorspringende Einhebelkante 8 im Inneren einer ebenfalls im Bereich der Stirnkante 12 der unteren Querschiene 10 befindlichen mindestens einen Eingriffsmulde 11 abstützen kann.

Üblicherweise sind am Endstück 1 noch Mittel vorhanden, über die der Betätigungshebel 4 bei Erreichen des in den Baugruppenträger vollständig eingeschobenen Zustands der Flachbaugruppe in der entsprechenden Position fixiert wird. Dieser eingeschobene Zustand ist in FIG 1 dargestellt. Vorteilhafterweise weist der Betätigungshebel 4 hierzu auf seiner Oberseite eine auf das Endstück 1 gerichtete, federnde und nach oben stehende Rastnase 24 auf, welche eine auf den Betätigungshebel 4 gerichtete und nach unten abgehende Rastkante 23 am Endstück 1 hintergreift.

In der gleichen Weise ist auch an dem in FIG 2 dargestellten Eckbereich der Flachbaugruppe 2 eine entsprechende Anordnung aus einem oberen Endstück 3 mit einem daran drehbar gelagerten oberen Betätigungshebel 4 angebracht. Dieser greift dann zum Ein- und Aushebeln in eine entsprechende obere Querschiene eines Baugruppenträgers ein (nicht abgebildet).

Bei dem Betätigungselement nach dem Stand der Technik gemäß FIG 1 und FIG 2 ist im unteren oder oberen Endstück ein Schaltelement 25 integriert, wobei dieses durch den Betätigungshebel 4 bei Vorliegen von dessen fixierter Position (Schaltstellung A) betätigt wird. Es ist hiermit möglich, die am Betätigungshebel 4 angebrachte Flachbaugruppe 2 elektrisch freizuschalten, z.B. durch Aktivierung von deren Stromversorgung. Umgekehrt kann die Flachbaugruppe 2 auch elektrisch passiv geschaltet werden, indem im Moment einer Aushebelung der Flachbaugruppe 2 der Eingriff des Betätigungshebel 4 auf das in das Endstück 1 integrierte Schaltelement 25 endet und durch diese Freigabe des Schaltelements 25 die elektrische Stromversorgung der Flachbaugruppe 2 wieder passiviert wird.

Das Schaltelement 25 ist in einem bis in den Bereich der Rastkante 23 des Endstücks 1 reichenden Aufnahmeschlitz 28 gelagert. Ein Schaltteil des Schaltelements 25, z.B. ein Schalthebel 29, ragt somit in den Bereich unterhalb der nach unten abgehenden Rastkante 23 hinein und wird bei Erreichen des fixierten Zustands des Betätigungshebels 4 (Schaltstellung A) durch den Schaltschieber 26 des Verriegelungselements 6 des Betätigungshebels 4 betätigt, wenn sich der Betätigungshebel 4 in der Position A befindet. Das Verriegelungselement 6 ist über ein Verbindungsteil 30 mit dem Schaltschieber 26 verbunden.

Wenn der Betätigungshebel 4 in die Position B (vgl. FIG 2) verschoben wird, wird der Schalthebel 29 entlastet und das Schaltelement 25 in einen zweiten Schaltzustand umgeschaltet, wobei insbesondere eine Passivierung der Flachbaugruppe 2 erfolgt.

Daraufhin kann ein Aushebeln des Betätigungshebels 4 erfolgen, in dem dessen Griffteil 5 nach unten - in Richtung der Querschiene 10 - bewegt wird, wodurch sich die Rastnase 24 des Betätigungshebels 4 elastisch von der Rastkante 23 des Endstücks 1 löst. Durch die Verschiebung des Verriegelungselements 6 zwischen den Positionen A und B nach FIG 2 kann das Schaltelement 25 aktiviert und passiviert werden, und zwar unabhängig von einem vollständigen Lösen des Betätigungselements durch das geschilderte Aushebeln des Betätigungshebels 4 nach unten zum Herausnehmen der Flachbaugruppe 2 aus dem Baugruppenträger.

Weitere Einzelheiten zum Aufbau des Betätigungselements gemäß dem Stand der Technik nach den FIG 1 und 2 und insbesondere zur Funktion des Verriegelungselements 6 gehen aus der Gebrauchsmusteranmeldung 299 22 725.1 (Siemens) hervor, deren Offenbarungsgehalt ausdrücklich in diese Anmeldungsunterlagen aufgenommen wird.

Vorteilhafterweise ist das integrierte Schaltelement 25 über eine an dessen Anschlusskontakten 16 anbringbare Kabel- oder Kabelsteckverbindung mit der Flachbaugruppe 2 elektrisch verbindbar.

Es ist somit möglich, das Schaltelement 25 dauerhaft sicher und verschleißfrei über das Betätigungselement zu betätigen, wenn die Schaltmittel des Schaltelements 25 nur einen sehr geringen Schaltweg aufweisen.

Da die Aktiv-Passiv-Schaltfunktion vollständig in das Betätigungselement integriert ist, unterliegen Anwender des Frontsystems keiner Einschränkung bezüglich der Positionierung von Bauelementen auf einer mit einem derartigen Frontsystem ausgestatteten Flachbaugruppe. Insbesondere sind dort keine masslich genauen Positionsfestlegungen bezüglich elektrischer Anschlüsse für das Schaltelement 25 erforderlich.

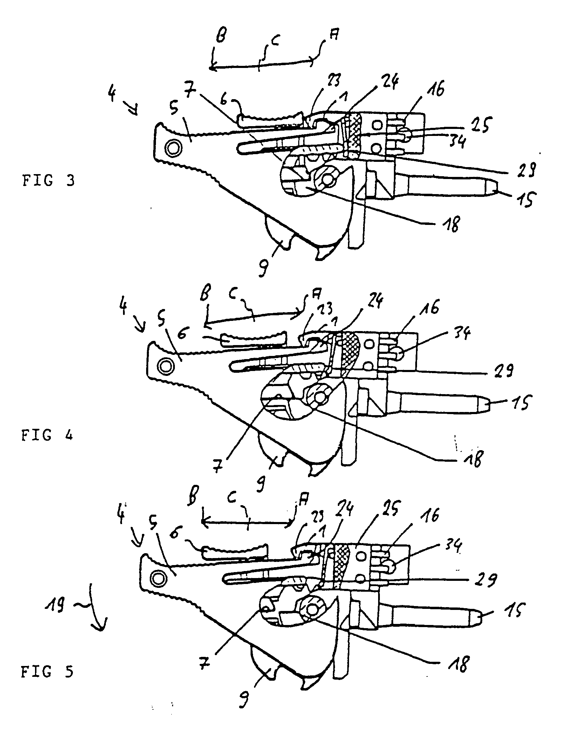

Soweit der Aufbau des erfindungsgemäßen Betätigungselements gemäß den FIG 3 bis 5 dem Aufbau des Betätigungselements nach dem Stand der Technik gemäß FIG 1 und FIG 2 entspricht, wurden identische Bezugszeichen verwendet, welche ohne ergänzende Erläuterung auch die bei der Figurenbeschreibung nach FIG 1 und FIG 2 dargestellten Funktionen besitzen.

FIG 3 zeigt eine seitliche Teilschnittdarstellung eines erfindungsgemäßen Betätigungselements mit einem Verriegelungselement 6 in Schaltstellung A. Dabei wird der Schalthebel 29 des Schaltelements 25 durch einen Schaltschieber 26 des Verriegelungselements 6 betätigt (1. Schaltzustand), wodurch z.B. die mit dem Schaltelement 25 verbundene Flachbaugruppe 2 aktiviert wird. Gleichzeitig wird bei Stellung des Verriegelungselements 6 in Schaltstellung A durch Aufliegen von dessen Gleitkante 7 auf dem Gleitanschlag 18 ein Abdrehen des Betätigungshebels 4 in Drehrichtung 19 vermieden. Damit befindet sich der Betätigungshebel 4 in einer eingehebelten und arretierten Position, die Rastnase 24 des Betätigungshebels 4 ist unter der Kante 23 des Endstücks 1 eingerastet.

In FIG 4 befindet sich das Verriegelungselement 6 in Schaltstellung C. Dabei befindet sich auch der Schaltschieber 26 des Verriegelungselements 6 in einer zurückgezogenen Position, so dass der Schalthebel 29 des Schaltelements 5 entlastet ist (2. Schaltzustand). Hierdurch wird die Flachbaugruppe 2 z.B. passiviert. Gleichzeitig kontaktiert weiterhin wie in der Schaltstellung A nach FIG 3 die Gleitkante 7 des Verriegelungselements 6 den Gleitanschlag 18 des Betätigungselements. Dadurch wird weiterhin sichergestellt, dass der Betätigungshebel 4 sich in einer arretierten und eingehebelten Position befindet und sich die Rastnase 24 weiterhin eingerastet unterhalb der Kante 23 des Endstücks 1 befindet.

FIG 5 zeigt das Verriegelungselement 6 in einer Schaltstellung B, nämlich in einer hinteren Endposition. Dabei ist wie in der Schaltstellung C gemäß FIG 4 weiterhin der Schalthebel 29 des Schaltelements 5 entlastet, die Flachbaugruppe 2 ist somit weiterhin passiviert. Zusätzlich ist durch die zurückgezogene Position des Verriegelungselements 6 in Schaltstellung B auch eine weitere Kontaktierung der Gleitkante 7 mit dem Gleitanschlag 18 aufgehoben. Damit kann der Betätigungshebel 4 in Drehrichtung 19 betätigt werden, wodurch ein Aushebeln der Rastnase 24 aus der formschlüssigen Verbindung mit der Kante 23 des Endstücks 1 erfolgen kann und schließlich ein Aushebeln der Flachbaugruppe 2 aus dem Baugruppenträger stattfinden kann.

Flachbaugruppe 2, Frontplatte 3 sowie Querschiene 10 sind in den Darstellungen gemäß den FIG 3 - 5 nicht abgebildet und entsprechen den Darstellungen gemäß den FIG 1 und 2. Soweit das erfindungsgemäße Betätigungselement auch nicht unterschiedlich beschrieben wurde, entspricht der Aufbau ebenfalls bei identischer Bezeichnung dem Aufbau eines Betätigungselements gemäß dem Stand der Technik nach FIG 1 und 2.

Durch die erfindungsgemäße in der Figurenabfolge der FIG 3 - 5 dargestellte Sequenz wird verdeutlicht, dass eine Entlastung des Schalthebels 29 des Schaltelements 25 (FIG 4) unabhängig von einer Entriegelung des Betätigungshebels 4 (FIG 5) erfolgen kann. Damit kann der Benutzer gezielt entscheiden, ob er nur eine Betätigung oder Entlastung des Schalthebels 29 des Schaltelements 25 anstrebt oder ob schließlich auch eine Aufhebung der Arretierung des Betätigungshebels 4 erzielt werden soll.

## Patentansprüche

1. Betätigungselement zum Ein- und Aushebeln einer Flachbaugruppe (2), mit
a) einem Endstück (1), welches zur Verbindung mit einer Flachbaugruppe (2) vorbereitet ist und
b) einem Betätigungshebel (4), der drehbar am Endstück (1) gelagert ist und zumindest aufweist,
b1) ein Griffteil (5) und
b2) ein Verriegelungselement (6), das zwischen zumindest zwei Schaltstellungen (A, B) verstellbar, insbesondere verschiebbar ist und das
b22) in einer ersten Schaltstellung (A) den Betätigungshebel (4) in einer ersten Position hält, welche einem eingehebelten Zustand der Flachbaugruppe (2) entspricht, und der
b23) in einer zweiten Schaltstellung (B) den Betätigungshebel (4) freigibt,
wobei das Betätigungselement ein Schaltelement (25) aufweist, welches in der ersten Schaltstellung (A) des Verriegelungselements (6) betätigt wird, **dadurch gekennzeichnet, dass** das Verriegelungselement (6) in eine dritte Schaltstellung (C) verstellbar ist, in welcher der Betätigungshebel (4) in der ersten Position gehalten wird, welche einem eingehebelten Zustand der Flachbaugruppe (2) entspricht und in welcher das Schaltelement (25) entlastet wird.

2. Betätigungselement nach Anspruch 1,
**dadurch gekennzeichnet, dass** das Schaltelement (25) im Endstück (1) des Betätigungselements integriert ist.

3. Betätigungselement nach Anspruch 1 oder 2,
**dadurch gekennzeichnet, dass** das Schaltelement (25) einen Schalthebel (29) aufweist.

4. Betätigungselement nach Anspruch 4,
**dadurch gekennzeichnet, dass** das Verriegelungselement (6) einen Schaltschieber (26) zur Betätigung des Schalthebels (29) aufweist.

5. Betätigungselement nach einem der vorhergehenden Ansprüche,
**dadurch gekennzeichnet, dass** das Verriegelungselement (6) eine Gleitkante (7) aufweist.

6. Betätigungselement nach Anspruch 5,
**dadurch gekennzeichnet, dass** die Gleitkante (7) einen Gleitanschlag (18) des Betätigungselements kontaktiert.

7. Betätigungselement nach Anspruch 6,
**dadurch gekennzeichnet, dass** beim Kontaktieren der Gleitkante (7) mit dem Gleitanschlag (18) eine Arretierung des Betätigungshebels (4) in einer eingehebelten Position erfolgt.

8. Betätigungselement nach einem der Ansprüche 5 - 7,
**dadurch gekennzeichnet, dass** keine Kontaktierung von Gleitkante (7) und Gleitanschlag (18) erfolgt, wenn sich das Verriegelungselement (6) in Schaltstellung (B) befindet.

9. Betätigungselement nach einem der Ansprüche 5 - 8,
**dadurch gekennzeichnet, dass** in einer Schaltstellung (C) des Verriegelungselements (6) eine Entlastung des Schalthebels (29) des Schaltelements (25) bei fortdauernder Arretierung des Betätigungshebels (4) in einer ersten Position erfolgt, welche einem eingehebelten Zustand der Flachbaugruppe (2) entspricht.

10. Frontsystem für eine Flachbaugruppe (2), welches aufweist eine Frontplatte (3) und mindestens ein Betätigungselement nach einem der vorangegangenen Ansprüche 1 - 9, das an einem Ende der Frontplatte (3) angebracht ist.

11. Flachbaugruppe (2) mit einem Frontsystem nach Anspruch 10.

12. Baugruppenträger mit mindestens einer Flachbaugruppe (2) nach Anspruch 11.

## Claims

1. Operating element for levering a printed circuit board assembly (2) in and out, having
a) an end piece (1), which is prepared for connection to a printed circuit board assembly (2), and
b) an operating lever (4) which is mounted in a rotatable manner on the end piece (1) and has at least
b1) a grip part (5) and
b2) a locking element (6) which can be moved, in particular displaced, between at least two switching positions (A, B) and which,
b22) in a first switching position (A), holds the operating lever (4) in a first position which corresponds to a levered-in state of the printed circuit board assembly (2), and which,
b23) in a second switching position (B), releases the operating lever (4),
with the operating element having a switching element (25) which is operated in the first switching position (A) of the locking element (6), **characterized in that** the locking element (6) can be moved to a third switching position (C) in which the operating lever (4) is held in the first position which corresponds to a levered-in state of the printed circuit board assembly (2) and in which the switching element (25) is relieved of load.

2. Operating element according to Claim 1, **characterized in that** the switching element (25) is integrated in the end piece (1) of the operating element.

3. Operating element according to Claim 1 or 2, **characterized in that** the switching element (25) has a switching lever (29).

4. Operating element according to Claim 4, **characterized in that** the locking element (6) has a switching slide (26) for operating the switching lever (29).

5. Operating element according to one of the preceding claims, **characterized in that** the locking element (6) has a sliding edge (7).

6. Operating element according to Claim 5, **characterized in that** the sliding edge (7) makes contact with a sliding stop (18) of the operating element.

7. Operating element according to Claim 6, **characterized in that** the operating lever (4) is arrested in a levered-in position when the sliding edge (7) makes contact with the sliding stop (18).

8. Operating element according to one of Claims 5-7, **characterized in that** no contact is made between the sliding edge (7) and the sliding stop (18) when the locking element (6) is in switching position (B).

9. Operating element according to one of Claims 5-8, **characterized in that**, in a switching position (C) of the locking element (6), the switching lever (29) of the switching element (25) is relieved of load when the operating lever (4) is continuously arrested in a first position which corresponds to a levered-in state of the printed circuit board assembly (2).

10. Front system for a printed circuit board assembly (2), which has a front panel (3) and at least one operating element according to one of the preceding Claims 1-9 which is fitted to one end of the front panel (3).

11. Printed circuit board assembly (2) with a front system according to Claim 10.

12. Mounting rack with at least one printed circuit board assembly (2) according to Claim 11.

## Revendications

1. Elément d'actionnement pour faire entrer et sortir, par un mouvement de levier, un module plat (2), comprenant
a) un embout (1) qui est prévu pour être connecté à un module plat (2) et
b) un levier d'actionnement (4) qui est monté à rotation sur l'embout (1) et qui présente au moins :
b1) une partie de préhension (5) et
b2) un élément de verrouillage (6) qui peut être déplacé entre au moins deux positions de commutation (A, B), notamment par coulissement, et qui,
b22) dans une première position de commutation (A), maintient le levier d'actionnement (4) dans une première position, qui correspond à un état du module plat (2) entré par mouvement de levier, et qui,
b23) dans une deuxième position de commutation (B), libère le levier d'actionnement (4),
l'élément d'actionnement présentant un élément de commutation (25) qui est actionné dans la première position de commutation (A) de l'élément de verrouillage (6),
**caractérisé en ce que** l'élément de verrouillage (6) peut être déplacé dans une troisième position de commutation (C) dans laquelle le levier d'actionnement (4) est maintenu dans la première position qui correspond à un état du module plat (2) entré par mouvement de levier et dans laquelle l'élément de commutation (25) est déchargé.

2. Elément d'actionnement selon la revendication 1,
**caractérisé en ce que** l'élément de commutation (25) est intégré dans l'embout (1) de l'élément d'actionnement.

3. Elément d'actionnement selon la revendication 1 ou 2,
**caractérisé en ce que** l'élément de commutation (25) présente un levier de commutation (29).

4. Elément d'actionnement selon la revendication 4,
**caractérisé en ce que** l'élément de verrouillage (6) présente un coulisseau de commutation (26) pour l'actionnement du levier de commutation (29).

5. Elément d'actionnement selon l'une quelconque des revendications précédentes,
**caractérisé en ce que** l'élément de verrouillage (6) présente une arête de glissement (7).

6. Elément d'actionnement selon la revendication 5,
**caractérisé en ce que** l'arête de glissement (7) vient en contact avec une butée de glissement (18) de l'élément d'actionnement.

7. Elément d'actionnement selon la revendication 6,
**caractérisé en ce que** lors de la mise en contact de l'arête de glissement (7) avec la butée de glissement (18), il se produit un blocage du levier d'actionnement (4) dans une position entrée par mouvement de levier.

8. Elément d'actionnement selon l'une quelconque des revendications 5 à 7,
**caractérisé en ce qu'**il ne se produit aucune mise en contact de l'arête de glissement (7) avec la butée de glissement (18) lorsque l'élément de verrouillage (6) se trouve dans la position de commutation (B).

9. Elément d'actionnement selon l'une quelconque des revendications 5 à 8,
**caractérisé en ce que**, dans une position de commutation (C) de l'élément de verrouillage (6), il se produit une décharge du levier de commutation (29) de l'élément de commutation (25) tandis que le levier d'actionnement (4) continue d'être bloqué dans une première position qui correspond à un état du module plat (2) entré par mouvement de levier.

10. Système frontal pour un module plat (2), qui présente une plaque frontale (3) et au moins un élément d'actionnement selon l'une quelconque des revendications précédentes 1 à 9, qui est monté sur une extrémité de la plaque frontale (3).

11. Module plat (2) comprenant un système frontal selon la revendication 10.

12. Support de module comprenant au moins un module plat (2) selon la revendication 11.
